# EUROPEAN PATENT SPECIFICATION

(11) **EP 1 785 230 B1**
(45) Date of publication and mention of the grant of the patent: **21.04.2010**
(21) Application number: 06255599.0
(22) Date of filing: 31.10.2006
(51) Int. Cl.: B24C 3/32, B24C 5/04, B24C 7/00, H01L 21/00, C23C 14/56

(54) **Method for slurry cleaning of etch chambers**
Verfahren zur Reinigung von Ätzkammern mit Schleif-Suspension
Procédé pour le nettoyage de chambres de gravure utilisent une suspension abrasive

(30) Priority: 14.11.2005 US 272844
(43) Date of publication of application: 16.05.2007
(73) Proprietor: Applied Materials, Inc., Santa Clara, CA 95054 (US)
(72) Inventor: Davis, Ian Martin, Chandler, Arizona 85225 (US); Laube, David Paul, Mesa, Arizona 85207 (US)
(74) Representative: Zimmermann & Partner

(56) References cited:
- EP-A- 1 103 878
- GB-A- 1 105 984
- US-A- 2 200 587
- US-A- 2 369 576
- US-A- 2 372 957
- US-A- 4 330 968
- US-B1- 6 554 909

## Description

The invention is directed to a cleaning method, according to claim 1.

Removal of contaminants from etch chamber components traditionally uses carbon dioxide pellet blasting, abrasive bead blasting, solvents, strong oxidizers, inorganic acids/bases or high temperature thermal decomposition. Depending on the contaminant/substrate combination, these produce marginal results in contaminant removal and providing high cleanliness surfaces for chamber reuse. These methods may also damage the substrate during the cleaning process particularly when using conventional mechanical cleaning methods for anodized and coated aluminum substrates. More recent designs of chamber components make use of plasma sprayed dielectric coatings such as Al₂O₃, ZrO₂, and Y₂O₃. These coatings are applied to ceramic and anodized aluminum substrates where coating adhesion is marginal at best and are easily damaged during cleaning due to the aggressive nature of conventional abrasive blasting techniques.

Clearly there is a real need for effective removal of deposits from all surfaces used during the process of creating a semiconductor wafer without degrading or damaging the substrate or coating surface.

Documents US 5 308 404 and US 6 554 909 describe dry and wet abrasive blast cleaning methods for semiconductor processing chambers and equipment.

Preferred features of the present invention will now be described, by way of example only, with reference to the accompanying drawings, in which:

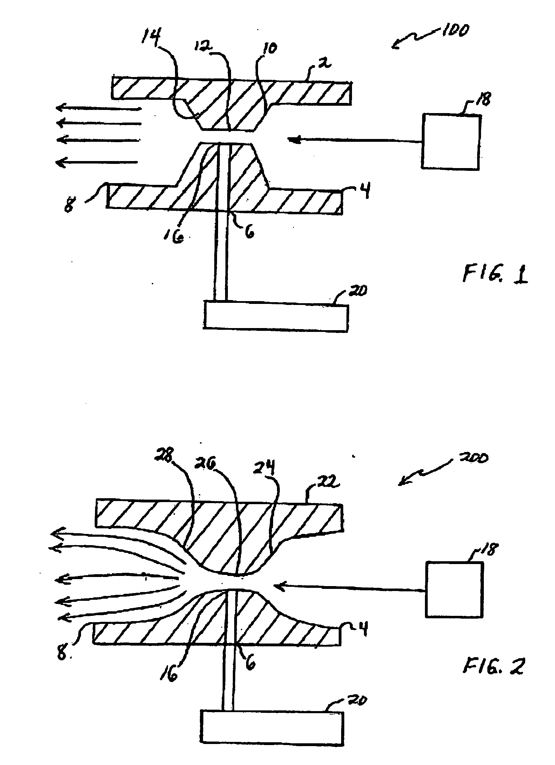

FIGS. 1 and 2 are schematic side elevation views of first and second apparatus embodiments for carrying out the present invention.

It is to be noted, however, that the appended drawings are not to scale.

In accordance with the present invention, a method is presented which overcome or reduce problems associated with previous methods and apparatus. Apparatus for carrying out the invention comprise an atomizing head functioning to produce an atomized abrasive slurry. The head comprises an abrasive slurry inlet, an atomizing fluid inlet, and an atomized abrasive slurry outlet. The atomizing head may include any internal volume capable of producing an atomized abrasive slurry, including a venturi, a converging-diverging nozzle, a converging nozzle, and other nozzle configurations.

In simplified terms there are three major methods for achieving atomization of a liquid or slurry:
1. rotating cup atomization involves shredding the fluid with the air of a moving mechanical element.
2. in mechanical atomization the fluid to be atomized is compressed to very high pressures (15 to 30 bars), thus imparting to it a high potential energy converted to kinetic energy when released to atmospheric pressure. This energy results in shearing of the liquid when it is brought into contact with the exterior atmosphere and thus results in the formation of droplets.
3. gaseous-fluid-assisted atomization can be used to arrive at a similar result while achieving a saving on high pressures (2 to 6 bars).

Apparatus for carrying out the present invention are concerned with the third category of atomization. In simplified terms one can distinguish two types of gaseous-fluid-assisted atomization according to whether the liquid to be atomized and atomizing fluid are brought into contact inside or outside the atomizer head. These types may be referred to as internal atomization and external atomization. Both types are useful in the present invention.

Internal atomization is characterized by confinement of the liquid and atomizing fluid in a contacting chamber. The mode of introduction of the two fluids into this chamber can vary considerably and has a direct influence on the characteristics of the atomized slurry that exits from the chamber. Likewise, the internal geometry of this chamber (overall volume, vanes for producing rotation, number and diameters of the inlet and outlet orifices, and so forth) also affects the specific characteristics of the liquid/atomizing fluid mixture. This mode of atomization generally affords an excellent quality of atomization, that is, an atomized slurry composed of very small slurry droplets with a very narrow droplet size distribution about these small diameters. At a given liquid delivery rate, this atomization quality is naturally a function of the atomizing fluid delivery rate employed and the pressure level prevailing in the interior of the atomizing chamber.

For external atomization, where contact between the two phases takes place outside of any confining enclosure, the atomized slurry is created mainly by shearing of the jet of liquid slurry by the atomizing fluid. The geometry of the outlets for the two fluids completely determines the quality of the atomization, and droplet size analysis of the drops resulting from the contact may show a relatively wide diameter distribution (simultaneous-presence of small and large droplets).

FIG. 1 is a schematic side elevation view of an embodiment of one apparatus 100 for carrying out the present invention, comprising an atomizing head 2 having an atomizing fluid inlet 4, an abrasive slurry inlet 6, and an atomized abrasive slurry outlet 8. Atomizing head 2 may be made from any suitable material or combination of materials, such as metal, plastic, and combinations thereof. Suitable metals include aluminum, stainless steels, such as 304 stainless steel. The stainless steel may be electropolished, but this is not a requirement. In apparatus 100, the internal flow channels include a converging nozzle 10, a parallel throat section 12, and a diverging nozzle 14. Throat 12 includes in this embodiment an inlet port or orifice 16 for abrasive slurry, which is drawn into throat 12 by negative pressure caused by flowing fluidizing fluid. Abrasive slurry may be drawn up from one or more abrasive slurry containers 20, and head 2 may have one or more fluid connections to one or more sources of fluidizing fluid 18. This particular flow configuration represents a venturi.

There are numerous options in the design of each particular atomizing head, and all are considered foreseeable alternatives. For example, in head 2 of FIG. 1, atomizing fluid inlet may be comprised of one, two, or more than two inlet orifices, as may abrasive inlet orifice 16. For example, it may be advantageous to place an inlet port or orifice 16a opposite of orifice 16.

FIG. 2 is a schematic side elevation view of another embodiment of an apparatus 200 for carrying out the present invention, similar to apparatus 100 illustrated in FIG. 1, comprising an atomizing head 22 having an atomizing fluid inlet 4, an abrasive slurry inlet 6, and an atomized abrasive slurry outlet 8. However in apparatus 200, the internal flow channels include a more streamlined converging-diverging nozzle 24, 28, and a throat 26. Throat 26 also includes in this embodiment an inlet port or orifice 16 for abrasive slurry, which is drawn into throat 26 by negative pressure caused by flowing fluidizing fluid. Abrasive slurry may be drawn up from one or more abrasive slurry containers 20, and head 2 may have one or more fluid connections to one or more sources of fluidizing fluid 18.

The abrasive slurry container, fluidly connected to the abrasive slurry inlet of the atomizing head, defines a space for a slurry comprising water, abrasive particles, and other optional ingredients, depending on the particular cleaning task, for example the type and quantity of debris or deposits to be removed, the underlying substrate composition and hardness, and the properties of any substrate coating, such as a refractory or dielectric coating.

The abrasive slurry container may be under atmospheric pressure, at a slight vacuum, or at a pressure above atmospheric, although the pressure in the container is not critical. The container may be closed or open to the atmosphere. If the container is at a pressure less than or greater than atmospheric the container will necessarily be manufactured to withstand these conditions. The container may comprise an outer shell with a bladder arrangement, where abrasive slurry is held inside the bladder. Air or other fluid may be used to force slurry out of the bladder, and a vacuum may assist loading the bladder with the abrasive slurry.

The configuration of the abrasive slurry container is not critical, as long the abrasive particles are able to be kept suspended, or reasonably so, in the container. There may be occasions when there are more abrasive particles than required for a particular task, in which case not all abrasives particles will need to be suspended. Some may be allowed to settle out to the bottom of the container until needed. The materials of construction of the slurry container are not critical. The container may be metal, plastic, or some combination thereof. A refractory or ceramic container may even be used, and a liner may be used. The liner may be a ceramic or plastic material. Suspension aids may be used. These may be chemical, mechanical or combination thereof. A mechanical suspension aide may comprise one or more stirring or agitating device. A chemical suspension aide may comprise one or more suspension aide chemicals. Examples of these latter are discussed further herein.

A source of atomizing fluid is fluidly connected to the atomizing fluid inlet. The source of atomizing fluid is selected from a membrane unit, an absorption unit, a cryogenic unit, a container of fluid, a compressor, a pipeline, a gas cabinet, and combinations thereof. The source of atomizing fluid may comprise a source of one or more inert gases and combinations thereof. If used, the inert gas may be selected from sources of nitrogen, argon, air, nitrogen enriched air, noble gases other than argon, and combinations and mixtures thereof. The atomizing fluid need not be a pure gas. For example, the atomizing fluid may be air, or nitrogen generated by a membrane separation unit producing nitrogen enriched air. Most nitrogen membranes generate nitrogen having about 90 to 95 percent nitrogen, although higher purity is possible by using multiple membrane units connects in series or in cascade fashion. Purities of higher than 95 percent may not be necessary. The dryness of the gas used may be a concern, for if the atomizing fluid is a gas and the gas has considerable water or other liquid, the composition of the atomized abrasive slurry might be different from that in the abrasive slurry container, possibly resulting in inconsistent results. The source of atomizing fluid is fluidly connected to the atomizing head by one or more conduits, which may include one or more pressure regulators adapted to adjust pressure of the atomizing fluid as it enters the atomizing head. If the amount of abrasive slurry feed to the atomizing head is maintained relatively constant, the pressure regulator may be adapted to adjust pressure of the atomized abrasive slurry as well. The pressure of the source of atomizing fluid may be any pressure required to atomize a particular slurry and perform the cleaning function. The pressure of the source of atomizing fluid may be controlled, such as by use of a gas cabinet, or it may be taken from a pipeline where there is little control over the pressure of the atomizing fluid in the pipeline.

In operation, an atomized abrasive slurry is directed onto at least one, preferably more than one internal surface of a semiconductor etching chamber. The method may include generating the atomized abrasive slurry by flowing an atomizing fluid through the atomizing head. Generating the atomized abrasive slurry may comprise controlling pressure of the atomized abrasive slurry exiting the atomizing head at a pressure ranging from about 25 to about 150 psig. The generating step comprises controlling density of the atomized abrasive slurry to a density ranging from about 0.01 gm/cc to about 0.2 gm/cc. It is desirous to control the momentum of the atomized abrasive slurry as it contacts the workpiece. The momentum of the atomized abrasive slurry at the workpiece may be controlled by controlling the momentum of the atomized abrasive slurry as it exits the atomizing head. The momentum of the atomized abrasive slurry exiting the atomizing head may be controlled with in a range of from about 100,000 gm-cm/sec to about 300,000 gm-cm/sec. The momentum of the atomized abrasive slurry as it exits the atomizing head may be controlled by adjusting the pressure of the atomizing fluid as it enters the atomizing head, the amount of slurry entering the atomizing head, the density of the abrasive slurry, or any combination of these.

The abrasive slurry may be maintained in a well-dispersed state in the abrasive slurry container. As noted previously, in the context of the invention this means the abrasive slurry may be a homogenous mixture of all ingredients.

Abrasive particles useful in the invention may be selected from those commonly used in the abrasive art, however, the abrasive particles (size and composition) will be chosen with the degree of surface roughness, coating thickness change, and adhesion properties in mind. In choosing an appropriate abrasive particle, characteristics such as hardness, compatibility with the intended workpiece, particle size, reactivity with the workpiece, as well as heat conductivity may be considered.

The composition of abrasive particles can be divided into two classes: natural abrasives and manufactured abrasives. Examples of natural abrasives include: diamond, corundum, emery, garnet, buhrstone, chert, quartz, sandstone, chalcedony, flint, quartzite, silica, feldspar, pumice and talc. Examples of manufactured abrasives include: boron carbide, cubic boron nitride, fused alumina, ceramic aluminum oxide, heat treated aluminum oxide, alumina zirconia, glass, silicon carbide, iron oxides, tantalum carbide, cerium oxide, tin oxide, titanium carbide, synthetic diamond, manganese dioxide, zirconium oxide, and silicon nitride.

Abrasive particles preferably have a particle size ranging from about 0.1 micrometer to about 1500 micrometers, more preferably ranging from about 0.1 micrometer to about 1300 micrometers. The abrasive particles preferably have an average particle size ranging from about 0.1 micrometer to about 700 micrometers, more preferably ranging from about 1 to about 150 micrometers, particularly preferably from about 1 to about 80 micrometers. It is preferred that abrasive particles have a Moh's hardness of at least 8, more preferably above 9; however, for specific applications, softer particles may be used.

The term "abrasive particle" includes agglomerates of individual abrasive particles. An abrasive agglomerate is formed when a plurality of abrasive particles are bonded together with a binder to form a larger abrasive particle which may have a specific particulate structure. The plurality of particles which form the abrasive agglomerate may comprise more than one type of abrasive particle and a binder.

Generally, fillers are inorganic particulate matter which comprise apparatus which are substantially inert or non-reactive with respect to the surface acted upon by the abrasive. Occasionally, however, active (i.e. reactive) fillers are used, sometimes referred to in the abrasives art as grinding aids. These fillers interact beneficially with the workpiece during use. In particular, it is believed in the art that the grinding aid may either 1) decrease the friction between the abrasive particles and the workpiece being abraded, 2) prevent the abrasive particle from "capping", i.e. prevent metal particles from becoming welded to the tops of the abrasive particles, 3) decrease the interface temperature between the abrasive particles and the workpiece or 4) decrease the required grinding force.

Grinding aids encompass a wide variety of different materials and can be inorganic or organic based. Examples of chemical groups of grinding aids include waxes, organic halide compounds, halide salts and metals and their alloys. The organic halide compounds will typically break down during abrading and release a halogen acid or a gaseous halide compound. Examples of such materials include chlorinated waxes like tetrachloronaphthalene, pentachloronaphthalene; and polyvinyl chloride. Examples of halide salts include sodium chloride, potassium cryolite, sodium cryolite, ammonium cryolite, potassium tetrafluoroborate, sodium tetrafluoroborate, silicon fluorides, potassium chloride, magnesium chloride. Examples of metals include, tin, lead, bismuth, cobalt, antimony, cadmium, iron titanium. Other miscellaneous grinding aids include sulfur, organic sulfur compounds, graphite and metallic sulfides. It is also within the scope of this invention to use a combination of different grinding aids and in some instances this may produce a synergistic effect. The above mentioned examples of grinding aids is meant to be a representative showing of grinding aids, and it is not meant to encompass all grinding aids.

Grinding aids may be used in abrasive slurries in amounts ranging from about 0.1 to about 10 dry weight percent, more preferably from about 0.5 to about 5.0 weight percent, based on total weight of slurry. If non-reactive fillers are employed they may be used up to 50 dry weight percent.

Abrasive slurries may contain any number of conventional additives such as one or more additional components, such as, for example, plasticizer, chelating agent, pH modifier, defoamer, foaming agent, reinforcing polymer, anti-freeze agent, suspension aid, bactericide, fungicide, and/or thickener.

Abrasive slurries may be prepared by mixing abrasive particles having known particle size ranging from 5 micrometers and known particle size distribution ranging from 1-75 micrometers with deionized water, and optionally other materials, to achieve slurry density ranging from about 0.01 gm/cc to about 0.2 gm/cc. The slurry may be mixed for 20 minutes at 1200 rpm using a high shear mixer, and the mixer may be left on during use of the slurry, but at lower rpm, in order to maintain a well dispersed slurry.

The abrasive slurry is converted into an atomized spray using an atomizing head having a venturi, similar to that illustrated schematically in FIG. 1. As an example, the atomizing head may be manufactured out of aluminum, and may have one or more slurry inlet orifices of diameter of about 1 cm, one or more air (atomizing fluid) inlet orifices of diameter of 1 cm, and one or more atomized slurry outlet orifices having a diameter of 2 cm. The abrasive slurry may be fed to the atomizing head through a flexible stainless steel tube, the abrasive slurry drawn into the atomizing head by air entering the atomizing head at a pressure of about 100 psig. The atomized slurry emerges from the atomizing head at a pressure of about 50 psig. The slurry tank may be maintained stirred as mentioned above. The slurry tank may be at atmospheric pressure and room temperature, although these conditions are simply convenient and not required. The atomized slurry may be directed at dielectric-coated surfaces of an etch chamber having deposits of silicon, silicon carbide, and other debris on the dielectric surface. The atomized slurry may be directed at the surfaces at a 90° angle, although other angles may be used. The pre-test roughness (Ra) of the dielectric surfaces are measured, as well as the post-test roughness after 30 seconds of contacting the atomized slurry to the dielectric surfaces. "Ra" is a common measure of roughness used in the abrasives industry. "Ra" is defined as the arithmetic mean of the departures of the roughness profile from the mean line. Ra may be measured with a profilometer probe, which has a diamond tipped stylus. In general, the lower the Ra value, the smoother or finer the workpiece surface finish. The profilometer known under the trade designation Perthen M4P may be used. Thickness of coatings may be determined by microsection techniques known in the art.

The method of the present invention may to be used to effectively remove debris from surfaces of semiconductor etching chambers. The scope of this invention is defined in the following claims.

## Claims

1. A method of cleaning a semiconductor etching chamber or chamber component comprising:
flowing an atomizing fluid through an atomizing head (2; 22) having an abrasive slurry inlet (6);
drawing an abrasive slurry from an abrasive slurry container (20) and into the abrasive slurry inlet (6) by negative pressure caused by fluidizing fluid; and
directing an atomized abrasive slurry onto at least some internal surfaces of a semiconductor etching chamber or chamber component, wherein the atomized abrasive slurry is composed of slurry droplets and has a density which is controlled to be within a range from 0.01 gm/cc to 0.20 gm/cc.

2. A method according to Claim 1, wherein the abrasive slurry comprises abrasive particles selected from silicon dioxide, calcium oxide, pumice, aluminum oxide, titanium oxide, zirconium oxide, and combinations of thereof.

3. A method according to Claim 2, wherein the internal surfaces of the semiconductor etching chamber or chamber component includes a dielectric coating selected from the group consisting of Al₂O₃, ZrO₂, and Y₂O_{3.}

4. A method according to Claim 3, wherein the generation of the atomized abrasive slurry comprises controlling pressure of the atomized abrasive slurry exiting the atomizing head.

5. A method according to any of Claims 3 to 4, wherein the pressure is controlled to be within a range from 25 to 150 psig.

6. A method according to any of Claims 3 to 5, comprising controlling momentum of the atomized abrasive slurry exiting the atomizing head.

7. A method according to Claim 6, wherein the momentum is controlled to be within a range from 100,000 gm-cm/sec to 300,000 gm-cm/sec.

8. A method according to any of Claims 3 to 7, wherein the generation of the atomized abrasive slurry comprises maintaining the abrasive slurry in the abrasive slurry container in a well dispersed state.

## Patentansprüche

1. Ein Verfahren zum Reinigen einer Halbleiterätzkammer oder -kammerkomponente, umfassend:
Strömen lassen eines Zerstäuberfluids durch einen Zerstäuberkopf (2; 22), der einen Einlass (6) für einen Schleifschlamm hat;
Ziehen eines Schleifschlamms aus einem Schleifschlammcontainer (20) und in den Einlass (6) für den Schleifschlamm durch negativen Druck, verursacht durch Verflüssigungsfluid; und
Leiten eines zerstäubten Schleifschlamms auf mindestens einige interne Oberflächen einer Halbleiterätzkammer oder -kammerkomponente, wobei der zerstäubte Schleifschlamm aus Schlammtröpfchen besteht und eine Dichte hat, die innerhalb eines Bereichs von 0,01 gm/cc bis 0,20 gm/cc zu sein kontrolliert wird.

2. Das Verfahren nach Anspruch 1, wobei der Schleifschlamm Schleifpartikel umfasst, die ausgewählt sind aus Siliziumdioxid, Calciumoxid, Bims, Aluminiumoxid, Titanoxid, Zirkoniumoxid und Kombinationen davon.

3. Das Verfahren nach Anspruch 2, wobei die internen Oberflächen der Halbleiterätzkammer oder -kammerkomponente eine dielektrische Beschichtung umfasst, die ausgewählt ist aus der Gruppe bestehend aus Al₂O₂, ZrO₂ und Y₂O₃.

4. Das Verfahren nach Anspruch 3, wobei die Erzeugung des zerstäubten Schleifschlamms Kontrollieren des Drucks des zerstäubten Schleifschlamms umfasst, der aus dem Zerstäuberkopf austritt.

5. Das Verfahren nach einem der Ansprüche 3 bis 4, wobei der Druck kontrolliert wird, in einem Bereich von 25 bis 150 psig zu sein.

6. Das Verfahren nach einem der Ansprüche 3 bis 5, umfassend Kontrollieren des Impulses des zerstäubten Schleifschlamms, der aus dem Zerstäuberkopf austritt.

7. Das Verfahren nach Anspruch 6, wobei der Impuls kontrolliert wird, in einem Bereich von 100.000 gm-cm/sec bis 300.000 gm-cm/sec zu sein.

8. Das Verfahren nach einem der Ansprüche 3 bis 7, wobei die Erzeugung des zerstäubten Schleifschlamms Halten des Schleifschlamms in dem Schleifschlammcontainer in einem wohlverteilten Zustand umfasst.

## Revendications

1. Procédé de nettoyage d'une chambre d'attaque de semi-conducteur ou d'un composant d'une telle chambre, comprenant :
l'écoulement d'un fluide d'atomisation au travers d'une tête d'atomisation (2;22) ayant une entrée (6) de bouillie abrasive ;
l'aspiration d'une bouillie abrasive depuis un réservoir (20) de bouillie abrasive, jusqu'à l'entrée (6) de bouillie abrasive, au moyen d'une pression négative causée par le fluide de fluidisation, et
le fait de diriger une bouillie abrasive atomisée sur au moins certaines surfaces internes d'une chambre d'attaque de semi-conducteur ou d'un composant d'une telle chambre,
procédé dans lequel la bouillie abrasive atomisée est composée de gouttelettes de bouillie et a une masse volumique commandée pour être dans une gamme allant de 0,01 g/cm³ à 0,20 g/cm³.

2. Procédé selon la revendication 1, dans lequel la bouillie abrasive comprend des particules abrasives sélectionnées parmi le dioxyde de silicium, l'oxyde de calcium, la pierre ponce, l'oxyde d'aluminium, l'oxyde de titane, l'oxyde de zirconium, et leurs combinaisons.

3. Procédé selon la revendication 2, dans lequel les surfaces internes de la chambre d'attaque de semi-conducteur et du composant d'une telle chambre incluent un revêtement diélectrique sélectionné dans le groupe consistant en Al₂O₃, ZrO₂ et Y₂O₃.

4. Procédé selon la revendication 3, dans lequel la génération de la bouillie abrasive atomisée comprend la commande de la pression de la bouillie abrasive atomisée sortant de la tête d'atomisation.

5. Procédé selon l'une quelconque des revendications 3 ou 4, dans lequel la pression est commandée pour être dans une gamme allant de 25 à 150 livres/pouce².

6. Procédé selon l'une quelconque des revendications 3 à 5, comprenant la commande de la quantité de mouvement de la bouillie abrasive atomisée sortant de la tête d'atomisation.

7. Procédé selon la revendication 6, dans lequel la quantité de mouvement est commandée pour être dans une gamme allant de 100 000 g-cm/s à 300 000 g-cm/s.

8. Procédé selon l'une quelconque des revendications 3 à 7, dans lequel la génération de la bouillie abrasive atomisée comprend le maintien de la bouillie abrasive dans le réservoir de bouillie abrasive à l'état bien dispersé.
